Europäisches Patentamt

European Patent Office

Office européen des brevets

(19)

(11) **EP 1 001 311 A1**

(12) **EUROPEAN PATENT APPLICATION**

(43) Date of publication:
**17.05.2000 Bulletin 2000/20**

(51) Int. Cl.$^7$: **G03F 7/00**, G03F 7/20,
G03F 1/14

(21) Application number: **99120594.9**

(22) Date of filing: **16.10.1999**

(84) Designated Contracting States:
**AT BE CH CY DE DK ES FI FR GB GR IE IT LI LU
MC NL PT SE**
Designated Extension States:
**AL LT LV MK RO SI**

(30) Priority: **16.11.1998 EP 98121744**

(71) Applicant:
**International Business Machines Corporation
Armonk, NY 10504 (US)**

(72) Inventors:
• **Biebuyck, Hans
Rockville, MD 20850 (US)**
• **Michel, Bruno
8134 Adliswil (CH)**
• **Schmid, Heinz
8820 Waedenswil (CH)**

(74) Representative:
**Klett, Peter Michael
International Business Machines Corporation,
Säumerstrasse 4
8803 Rüschlikon (CH)**

(54) **Patterning device**

(57)     A patterning device is proposed with which incident light is guidable at least partially to at least one cover element which is in contact with the patterning device. The cover element comprises light-sensitive material and is arranged on top of a substrate protrusion element on a surface of a substrate and/or is itself structured on a substrate.

Fig. 1a

EP 1 001 311 A1

**Description**

TECHNICAL FIELD

The present invention concerns a new scheme for optical lithography that allows extension of optical lithography beyond the conventional resolution limits imposed by the wavelength of the exposing light.

BACKGROUND OF THE INVENTION

The resolution of conventional optical lithography schemes is mainly limited by the wavelength of the light used for the transfer of a mask pattern onto a resist. The wavelength of the exposing radiation is a main determinant of pattern resolution W, given by the Rayleigh equation $W = k_1 \lambda / NA$, where $\lambda$ is the wavelength of the exposing light, NA is the numerical aperture of the optical lithography tool, and $k_1$ is a constant for a specific lithography process. In other words, the resolution W is proportional to the wavelength $\lambda$ of the exposing light. Cutting-edge production today creates features that are 250nm wide, using 248 nm illumination. Currently, the implementing schemes based on light are the bottleneck when trying to obtain structures of a feature size below 200nm. State-of-the-art optical lithography systems for making current DRAMs, for example, are quite expensive. Alternative processes become attractive when moving on to smaller feature sizes, but the required investments are huge. Thus, techniques that maintain compatibility with existing processes are inherently valuable.

Trends in integrated-circuit- and flat-panel-display-manufacturing technologies require improvements in small-scale lithography. In these and other fields, there is an increasing demand for a cost-effective lithographic technique that can produce large fields (e.g. approximately 45 cm diagonal for displays) of nanoscale structures. The semiconductor industry road map calls for leading-edge manufacturing at 180 nm in the year 2001 and 70nm in the year 2011.

One well-known form of optical lithography is the so-called hard-contact lithography, where a mask is put directly into contact with a substrate to be patterned. Features on the mask, comprising alternatively translucent and opaque regions in a well-defined pattern, are transferred into a photoresist in a 1:1 relation to their dimensions on the mask. Hard-contact lithography can, in principle, make structures with sizes below the wavelength of illumination, but the contact used to place the mask on the substrate compromises the integrity of the process as the possibility of confounding material on the surface of the mask and mask damage greatly limit the useful number of times the mask can be used. Cost is particularly worrisome as the feature scale shrinks and the expense of mask fabrication skyrockets with the increase in the density of its features. Contact masks are also generally much more expensive than those used in optical-projection lithography since for an equivalent resolution the critical dimensions in the former need to be smaller than those in the latter, by the reduction factor used in a projection system. Dust particles and other physical impediments to the substrate are catastrophic in hard-contact lithography as they lift the mask away from the surface, blurring the pattern. Such defects appear over an area much larger than the obscuring particle because the mask is unable to conform around their presence; this problem is compounded as the feature scale shrinks such that even a 200 nm particle can be harmful. In addition, the resist can get stuck to the mask. Hard-contact lithography has thus not found a significant role in manufacturing of small-scale integrated circuits.

There are many approaches known, that improve conventional lithography systems in that filters, projection lenses, or appropriately modified masks are employed. These approaches get more and more complicated and expensive with reduced feature scale. One example here is the so-called optical-projection lithography. The optical lithography based on projection is a very successful and widely employed means of making features down to 200 nm. Here, a pattern of intensity variations in the far field results when light is shone through a mask like that used in contact lithography. The light propagates through air and is focused by a lens to create an image of the desired pattern on a resist-covered substrate, often demagnified by a factor of 5-10 from its size on the mask. Projection lithography is largely limited to features sizes equal or larger than the wavelength $\lambda$ of light. Its implementation becomes increasingly difficult as the scale shrinks towards and below 200 nm, where very complicated systems of lenses and materials are required to carry out existing and proposed schemes. The area over which uniform illumination can be achieved is particularly problematic. The maximum current field size with the best 248-nm-exposure tool is now only ~30 x 30 mm.

It is generally a disadvantage of most of these approaches that they are getting more and more complicated and expensive when trying to obtain smaller feature sizes. Furthermore, there is a tradeoff between maximum resolution, depth of focus and achievable field image which comes from the use of a lens to focus the light.

The resolution of standard photolithography systems can be increased and feature size decreased by using masks that manipulate the phase instead of the amplitude of the light used for exposure. Such masks are referred to as phase masks, phase shifting masks or PSMs. Two examples of phase shift-based approaches are described by D.M. Tennant et al. in "Phase Grating Masks for Photonic Integrated Circuits Fabricated by E-Beam Writing and Dry Etching: Challenges to Commercial Applications", Microelectronic Engineering, Vol. 27, 1995, pp. 427-434, and by J.A. Rogers et al. in "Using an elastomeric phase mask for sub-100 nm photolithography in the optical near field", Appl. Phys. Lett., No. 70, Vol. 20, 19 May 1997, pp. 2658-2660.

Tennant et al. propose the use of hard-contact masks, whereas Rogers et al. favor elastomeric masks for the formation of high-density sub-wavelength features. In these methods, the pattern on the mask results in interference in the illumination arising in the near field from contact between a photoresist and the structured mask. Light passes everywhere through the mask which is completely translucent but has a pattern of surface reliefs that vary in a well-defined manner. Light traveling through such a structured mask experiences a comparatively longer or shorter path depending on the place of its exit. This change in the effective path length through the structured mask leads to phase differences in the propagating light. These phase differences result in sub-wavelength nodes in intensity of the exposing radiation at the surface of the resist. If these masks are designed and made appropriately, there are nodes at the mask/resist interface with a relative minimum in intensity.

Rogers et al. show that using a phase approach with an elastomeric mask allowed them to make sub-wavelength features in a photo resist layer while avoiding the problems associated with brittle contact masks. These features can then be transferred into a substrate by means of dry etching, or wet chemical dissolution of the substrate, as is well known in the art. The features formed in the substrate have about the same lateral dimensions as the features formed in the photoresist. The problem with the aforementioned approaches to lithography based on phase-shifting of light through a mask is that, while small features can be generated, these features are constrained to a one dimensional geometry, i.e. lines, and low density on the substrate. Further, the shape of the structure in resist is limited. In the paper of Rogers et al., the authors show that the phase shift in the light intensity provides structures in the resist that are related to the derivative of the topology in the phase mask, i.e. each wall in the pattern of surface reliefs in the phase mask gives rise to a relative minimum in the light intensity at the surface of the resist. The width of this node is narrow but fixed so that only a very limited variation in the range of the lateral sizes of these features is possible.

Making dots, squares or other filled structures of arbitrary shape is not obviously possible in a single step by this technique. Moreover, in order for the phase shift to be present at all, the height of the surface reliefs in the phase mask must closely match the wavelength of the exposing light. This requirement means that the structures in a phase mask are constrained to become increasingly anisotropic as their dimensions shrink, a significant problem in the formation of such features in elastomeric materials. It is another problem of this approach that there always are twin structures exposed in the resist, because each protrusion of the phase mask generates a pair of nodes of low intensity at its edges.

The problem of mask fabrication described above remains as well as the susceptibility of the process to defects and damage. The use of an organic polymer to form the mask allows their convenient formation by a variety of techniques, perhaps most notably by replication of the mask from a master. Many polymeric masks can be cast on a single master with no evident wear of the latter since the process exerts no or very little stress on the substrate. Replication of masks avoids some of the problems associated with the costs of their use in contact lithography for the formation of high-density small structures: the replica can be made so cheaply as to allow its use only once prior to its disposal. Not all structures are possible in many of the most convenient polymers, such as the elastomeric polydimethylsiloxane used by Rogers et al., for these applications. The paper "Stability of Molded Polydimethylsiloxane Microstructures" by Delamarche et al. (Advanced Materials 1997, 9, p. 741) shows that many features in ordinary elastomers collapse and tend toward increasingly poor definition and their anisotropy increases and their feature scale decreases, respectively.

There are proposals concerning other approaches and schemes by means of which the resolution of optical lithography systems can be somewhat extended to smaller feature sizes. An example is given in an article by H. Fukuda et al. with the title "Can synthetic aperture techniques be applied to optical lithography?", published in J. Vac. Sci. Technol. B, Microelectron. Nanometer Struct. (USA), Vol. 14, No. 6, Nov. Dec. 1996, p. 4162-4166. This article discusses the theoretical feasibility of applying optical-aperture synthesis to lithography. A technique involving the insertion of three phase gratings into a conventional projection system is described. While this approach paraxially yields imaging with doubled spatial bandwidth, aberrations introduced by the gratings are shown to be a serious limitation. Image simulations demonstrate that for very restricted pattern types, a resolution down to 0.1 μm is theoretically achievable.

Using expensive optics and existing laser sources and photoresists, interferometric lithography can be extended to beyond the horizons of the current industry road maps, as described by Ch. Xiaolan et al. in "Multiple exposure interferometric lithography-a novel approach to nanometer structures", Conference Proceedings - Lasers and Electro-Optics Society Annual Meeting 1996, p. 390-391.

More exotic schemes for sub-200 nm lithography are also being considered. X-ray, extreme UV and projected beams of electrons are the object of active research for manufacturing application. The problems with these techniques range from the difficulties of mask fabrication, the implementation of practical beam-formation techniques, the need for novel resist materials that allow a functional and sensitive use of the beam intensity, practical problems in forming and stabilizing the beam and the ever present limitations of cost and complexity.

It is hence a first object of the invention to provide a very simple and consequently low-cost solution for small-feature generation lithography.

It is another object to provide a patterning device which offers a high precision and a high contrast in the produced pattern.

It is another object to provide a multiply reusable patterning device.

It is another object to provide a patterning device with a high degree of self-alignment, particularly for creating stacked structures, like semiconductor arrangements where several layers are to be deposited at exactly the same vertical position and with exactly the same lateral dimensions above each other. Hereby, by using the invention's concept, expensive alignment structures are no longer needed and simultaneously the yield of qualified patterned products rises.

SUMMARY OF THE INVENTION

The above objects have been accomplished by providing a patterning device with which light is guided to a cover element on a substrate. The cover element is structured in that it has depressions and protrusion elements. This can either be achieved by having a structured substrate, i.e. having substrate protrusion elements, which is covered with the cover element, such that the structure of the substrate is reflected in the resulting structure of the cover element which hence has the depressions and the protrusion elements due to the underlying substrate protrusion elements. Or the cover element itself is structured and has depressions and protrusion elements. Also both effects can be combined.

The goal is to selectively guide light to the protrusion elements of the cover element while the depressions of the cover element are not or only to a much lesser extent exposed to light.

The cover element comprises light-sensitive material, such that the light which arrives at this cover element alters the material of the cover element. The light is coupled to the cover element preferably through conformal contact between the patterning device, respectively a light-guiding protrusion element of it, and the cover element. The light leaves the patterning device mainly only where the light-guiding protrusion elements touch the cover element. At the other positions, internal reflection hinders the light from leaving the patterning device.

Because the part of the cover element which is to be exposed to the light is protruding from the substrate, the patterning device in its simplest embodiment may consist only of a flat, unstructured, elastic light-guiding plate, sheet, layer, disk or the like. It then touches only the protrusion elements of the cover element.

A subsequent developing step removes either the part of the cover element which has been exposed to the light or the part which has not been exposed.

Consequently, in the case when the cover element was deposited on a structured substrate, a naturally self-aligned pattern is the result, namely the substrate protrusion elements are in the case of a removal of the exposed cover element free for e.g. being selectively covered with layer elements or being treated in any other way. The selection for the layer element coverage treatment can be achieved by covering again the whole surface with a layer which then comprises the layer elements on the substrate protrusion elements, layer elements on the cover element upon the substrate protrusion elements and also layer elements near the substrate protrusion elements and on the cover element. A following lift-off procedure removes the cover element with the layer elements, such that the substrate protrusion elements remain with the layer elements exactly aligned thereupon.

ADVANTAGES OF THE INVENTION

In the dependent claims, various modifications and improvements of the investigation and/or manipulation device are contained.

When the light-guiding protrusion element comprises an elastomer, it inherently provides a property which is suited for achieving a high degree of conformity towards the cover element.

When the light-guiding protrusion element comprises a material which has a refractive index which effects that the incident light is guided therein by internal reflection, no or only few or less effective means need be provided to achieve internal reflection. The internal reflection is a practical effect used to obtain the desired contrast.

A refractive-index match between the materials of the light-guiding protrusion element and of the cover element is advantageous because the coupling efficiency is increased. The preciser the match, the higher is the difference against a surrounding medium which has a refractive-index difference compared to the material of the patterning device. With the refractive-index match grows the obtainable contrast. Hence the advantage of a material which connects the surfaces of the light-guiding protrusion element and of the cover element with each other such that an eventual discontinuity in the refractive-index profile becomes smoothened, is apparent. Such a material can ideally be a liquid such as an oil.

Using reflecting means for increasing the amount of light reflected back into the interior of the patterning device at positions where no leaving of that light is desired, increases the achievable contrast in two ways. On one hand, less light is leaving at these positions. On the other hand, this light is led to the positions with contact to the cover element where this light contributes to the desired illumination. The below-described amplification thereby is increased.

The most easy-to-manufacture reflecting means are a simple cover layer or a Bragg-grating.

The patterning device may in an advantageous manner be designed such that it is held on the cover element merely by gravitational forces and/or interfacial forces. No additional force need be exerted on the patterning device which leads to a lower probability of wear and hence a higher rate of repetable use of one single patterning device. Furthermore, the absence of additional forces decreases the probability of a deformation of the patterning device which leads to a higher patterning precision. Third, this renders superfluous the provision of a respective force-exerting mechanism which makes the apparatus and method for pattering cheaper.

The wavelength of the light insofar plays a role as it may limit the achievable pattern definition, i.e. the minimum feature size. It is also influencing the resulting pattern in that eventual interferential effects can occur depending on the geometrical dimensions of the patterning device.

It is another important advantage that no imaging optics are required. Large areas can be structured in single exposures since the present approach is inherently parallel as all features on the substrate can be exposed simultaneously, thereby providing a high throughput. The device and method can be used for large field images and is thus well suited for the manufacturing of displays as well as the batch-processing of semiconductor chips, such as DRAMs and so forth, and wherever else the formation of high-density small structures is required. The patterning device and method is also well suited for the formation of micro-mechanical structures.

The elastomeric patterning device can be easily replicated from a master copy, and each replica can be used many times. In the case of an unstructured patterning device, not even a replication is needed. The absence of need of alignment or at least the need only of a coarse alignment is a particular advantage because the alignment step is one of the most cost-intensive and yield-reducing steps in manufacturing. On the other hand, if alignment is used, at least the yield is significantly increased by the reduced alignment definition requirement.

It is another advantage that compatibility with existing resist and processing technologies is maintained which again leads to less costly production becasue no new machinery is needed.

It is a further advantage that one can make use of the huge amount of experience in the design and handling of resists, because resists can be used as the cover element. This avoids mistakes and seacrh for the optimum processing parameters. The manufacturing process gets cheaper and has a higher yield.

It is a further advantage, that multiple wavelengths can be used without adjustment of the light-guiding element, since lenses are not used. This makes the apparatus for illumination cheaper and easier to handle.

It is another advantage that the time of exposure is shorter than in case of conventional masks because lenses and other means do not block, absorb or scatter the light unproductively. The shortened exposure time leads to higher production throughput and energy- and material saving.

DESCRIPTION OF THE DRAWINGS

The invention is described in detail below with reference to the following schematic drawings:

Fig. 1a    a cross-section of a patterning device in contact with a substrate with a cover element.

Fig. 1b    the substrate of fig. 1a with the developed part of the cover element removed,

Fig. 1c    the arrangement of fig. 1b with layer elements deposited on it,

Fig. 1d    the arrangement of fig. 1c with the whole cover element removed,

Fig. 2a    the patterning device with no reflecting element,

Fig. 2b    the patterning device with two inclined planes as reflecting element,

Fig. 2c    the patterning device with a reflective layer as reflecting element,

Fig. 2d    the patterning device with a Bragg grating as reflecting element,

Fig. 2e    the patterning device with a light-blocking layer as the reflecting element,

Fig. 3    a magnetized view of a light-guiding protrusion element contacting the cover element,

Fig. 4    a patterned resist structure illuminated with a flat stamp to increase the aspect ratio of the preexisting feature,

Fig. 5    a patterned resist structure illuminated with a stamp using evanescent light to create a thin layer with increased permeability.

DETAILED DESCRIPTION

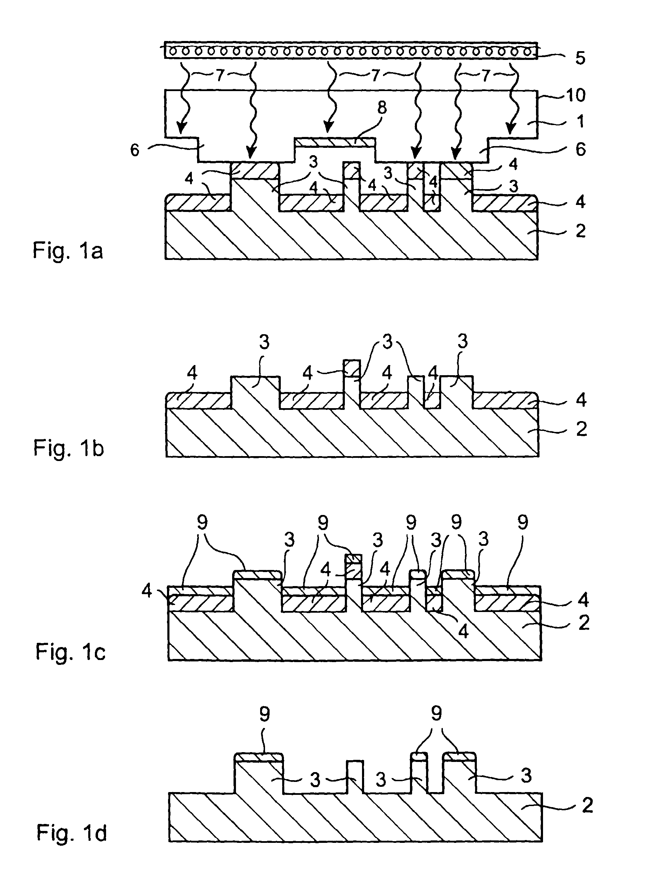

In figure 1a an arrangement for patterning a substrate 2 is shown.

The substrate 2 is generally a flat layer, e.g. made of silicon. It bears several substrate protrusion elements, also called protrusion elements 3, on its upper surface. The surface of the substrate 2 with the substrate protrusion elements 3 is covered with a layer made of light-sensitive material, called the cover element 4. The thickness of this cover element 4 is here smaller than the height of the substrate protrusion elements 3. Thereby the cover element 4 is separated into several non-connected portions. Some of these portions fill the spaces between the substrate protrusion elements 3 and some of them rest on top of the substrate protrusion elements 3.

A patterning device 10 comprises a flat light-guiding body element 1 which is unified with several light-guiding protrusion elements 6 at its underside. Between the light-guiding protrusion elements 6, a reflecting means 8 is arranged. The patterning device 10 is positioned on the substrate 2 such that the light-guiding protrusion elements 6 get into contact with some portions of the cover element 4, all of which are on top of a respective substrate protrusion element 3.

The material of the patterning device 10 is chosen elastic, such that the contact between the light-guiding protrusion elements 6 and the adjacent cover element 4 is conformal. The surfaces of the light-guiding protrusion elements 6 which get into contact with the cover element 4 hence to some extent adapt to the surface of the cover element 4. Furthermore, the material of the patterning device 10, or more particularly of its light-guiding protrusion elements 6, is chosen to have a refractive index which matches the refractive index of the material of the cover element 4. 'Matching' means here that the difference between these refractive indices should be as low as possible. A decisive influence on this parameter has also the refractive index of the medium in which the described arrangement is situated. More particularly, it is the medium which fills the space between the surface of the patterning device 10 and the substrate 2, and even more precisely, it is the medium which is adjacent to the surfaces of the light-guiding protrusion elements 6. The refractive index of this medium should be as different as possible from the refractive indices of the materials of the light-guiding protrusion elements 6 and of the cover element 4. The higher this difference is, the higher may be the tolerable refactive index difference between the material of the cover element 4 and of the light-guiding protrusion elements 6.

The patterning device 10 is illuminated from a light source 5 with light 7 incident on the patterning device 10 from its upper side. The light is hence coupled into the patterning device 10 at its upper surface. The light 7 enters the patterning device 10 and then propagates through it. The patterning device 10 provides a light-guiding function for the light 7 in that it guides it to the light-guiding protrusion elements 6 and from there to those parts of the cover element 4 which are in contact with the light-guiding protrusion elements 6. For the guiding function, on one hand, the light 7 which enters the patterning device 10 is reflected back into the internal of the patterning device 10 by the reflecting element 8, on the other hand, the interface between the light-guiding body element 1 and the surrounding medium also effects such a reflection, particularly becasue of the refractive index difference. The patterning device 10 hence serves as a lightwaveguide.

Air is here exemplarily contemplated as the surrounding material. When used in an environment other than air, such as an inert gas, liquid or the like, a material with an appropriate refractive index may be used for the patterning device 10 to ensure that the light 7 is properly guided by means of internal reflection.

The material of the patterning device 10 and the material of the cover element 4 have refractive indices which are here chosen as close together as possible. When these materials have well-matching refractive indices and are in conformal contact to each other, electromagnetic fields can propagate across their interface without or with only low dispersal. Conversely, the light 7 at refractive-index-mismatched surfaces, such as at the interface of the patterning device 10 towards the surrounding air, is more strongly reflected.

The structure of the substrate 2, namely the existence of the substrate protrusion elements 3, gives rise to localized coupling of the light 7 out of the patterning device 10 into the cover element 4. It already becomes apparent that the patterning device 10 need not be structured, i.e. have the light-guiding protrusion elements 6, but can be even a flat sheet, layer, disk or the like which simply is laid upon the structured substrate 2.

The conformity of the contact between the patterning device 10 and the cover element 4 adds to the index-matching in that the gap between the patterning device 10 and the cover element 4 is minimized and as a consequence, the disturbing effect of a different refractive index of the surrounding medium is reduced.

The better the coupling conformity between the cover element 4 and the patterning device 10 and the better the index match, the higher is the resulting illumination contrast between the parts of the cover element 4 which are in contact with the patterning device 10 and those parts of the cover element 4 which are not in contact with the patterning device 10. The best conformity effects that the refractive index appears continuous across the interface between the patterning device 10, respectively the light-guiding protrusion elements 6 and the cover element 4 in contact.

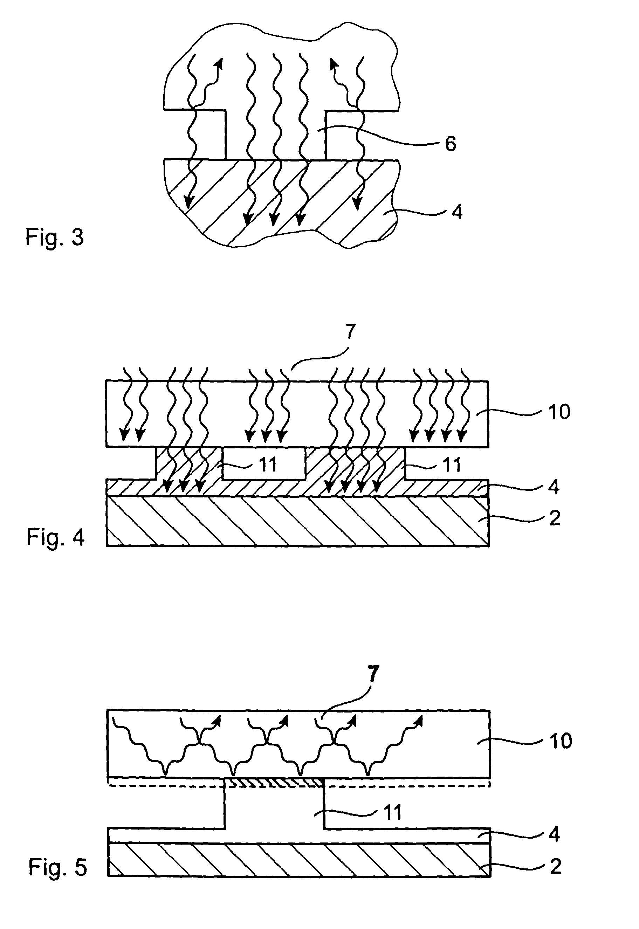

The contrast is important because it determines the precision of the result which is to be achieved with the locally selective exposure of the cover element 4. For better understanding, the contact between the light-guiding protrusion elements 6 and the cover element 4 is depicted in a magnetized view in figure 3.

The touching surfaces of the light-guiding protrusion elements 6 and the cover element 4 define regions of strong lateral confinement for the light 7, which means that it prefers to leave the patterning device 10 through the interfaces which are in contact with the cover element 4. It has been found that the light 7 is not only confined but also amplified in the contacting regions. The electromagnetic field prefers to propagate along paths of higher polarizability as it travels through the patterning device 10. The light 7 even experiences an amplification depending on the geometrical dimensions of the arrangement. More precisely, the ratio between the area where the light-guiding protrusion elements 6 and cover element 4 are in contact and the area where no such contact exists, is directly related to the extent of amplification. Simply spoken, the light 7 which is prevented from leaving the patterning device 10 at its interfaces to the surrounding medium, is for sake of preservation of energy, instead leaving the patterning device 10 through the interfaces which are in contact with the cover element 4.

The achieved effect is hence that much more light enters the cover element 4 where it is in contact with the light-guiding protrusion elements 6 than light enters the cover element 4 where it is not in contact with the light-guiding protrusion elements 6.

The material of the cover element 4 is light-sensitive and is chemically altered by the illumination. Hence, after illumination, the layer of light-sensitive material is patterned. Because of the regions which are filled with the surrounding medium with a different refractive index, the light 7 has remained sufficiently confined to provide contrast in its intensity at the interface between the light-guiding protrusion elements 6 and the cover element 4 to be patterned. The conformity of the light-guiding protrusion elements 6 ensures a high level of coupling and leads to a close index match at the interface to the cover element 4 and thus suppresses unfavorable scattering of light. Hence, the resulting contrast between the parts of the cover element 4 which are to be illuminated and those parts of the cover element 4 which are not to be illuminated is increased.

After a predetermined time of illumination, the patterning device 10 is removed from the substrate 2 with the substrate protrusion elements 3.

The material of the cover element 4 serves as a kind of photoresist for the underlying material of the substrate 2 with the substrate protrusion elements 3. Here the material is a positive resist, i.e. a resist where the areas which were exposed to the light 7 become soluble in a solvent. Hence only the areas which were not exposed to the light 7 remain stable when exposing the resist to the appropriate solvent, which is called developing.

Figure 1b shows the situation after the exposure to the light 7, removal of the patterning device 10 and subsequent developing. The parts of the cover element 4 which have been in contact with the patterning device 10 through its light-guiding protrusion elements 6 and hence have been exposed to the light 7, are removed in the development process, such that the underlying material of the substrate protrusion elements 3 is uncovered.

The blocking function of the patterning device 10, i.e. the function of hindering the light 7 to leave the patterning device at positions where it should instead be reflected back to the internal may be improved by adding additional means. Also the light-guiding and coupling properties of the light-guiding protrusion elements 6 may be improved by appropriate measures.

The exposing light 7 can be polarized, monochromatic, polychromatic or incoherent, preferably with wavelengths between 800 and 200 nm. Broadband light can be generated by a mercury lamp, for example. Argon ion lasers, YAG lasers, KrF lasers can be used as the light source 5. The light source 5 may be a far field, unfocused source. The light 7 emitted by the light source 5 can be coupled into the patterning device 10 through any of its interfaces. The light 7 might be coupled into the patterning device 10 by means of a waveguide or a fiber from the top or side. The wavelength of the light 7 may be chosen optimized for a particular application. The light 7 may be pulsed, if deemed appropriate. Additionally, the light 7 can be scanned over the patterning device 10 or projected onto it in a pattern, e.g. when a projection system with an additional mask is used as the light source 5.

The interface to the surrounding medium should be designed such that the light 7 is guided by means of internal reflection towards the light-guiding protrusion elements 6 which are in conformal contact with the parts of the cover element 4 to be exposed. At the interface between the ends of the light-guiding protrusion elements 6 and the cover element 4, the light 7 is coupled right into the cover element 4, i.e. the arrangement there should be designed such that this coupling between light-guiding protrusion element 6 and cover element 4 is efficient.

Practically, modulations in the light intensity of a factor of two and even less between areas on the cover element 4 in and out of contact with the end of the light-guiding protrusion elements 6 provide sufficient difference in the resulting exposure of the contacted parts of the cover element 4 compared to the noncontacted parts of the cover element 4.

Part of the light 7 leaking out of the patterning device 10 at positions where the light-guiding protrusion elements 6 do not touch the cover element 4 lowers the contrast. The reflecting element 8 can also reduce such interference-based contrast reduction, but is not generally needed.

The coupling efficiency depends on the refractive index of both the light-guiding element 6 and the cover element 4, on the wavelength or wavelength range if polychromatic light is used. There are different means how to optimize the coupling efficiency. The principal target is to reduce a refractive index discontinuity between the light-guiding protrusion element 6 and the cover element 4 to scales less than the wavelength. This situation is most readily accomplished by conformal contact between the two surfaces, that is an intimate matching between the two surfaces. Ideally, the index of both the light-guiding protrusion element 6 and the cover element 4 are as high as possible since this causes a decrease in the effective wavelength of illumination used to carry out the lithography. Several possibilities exist to achieve this conformity.

First, pressure can be applied to sandwich the substrate 2 and the patterning device 10 together. Second, the cover element 4 can be made compliant by control over its composition and handling, allowing it to accommodate to the surface of the light-guiding protrusion elements 6 of the patterning device 10, insuring an intimate contact. Third, a thin layer of index-matching material can be added to the light-guiding protrusion elements 6 like a viscous oil or polymer that serves to couple optically the light-guiding protrusion elements 6 to the cover element 4. The index-matching material is understood here to be compliant and can even be localized to the light-guiding protrusion elements 6 to maintain the overall refractive index contrast. Fourth, the patterning device 10, particularly the light-guiding protrusion elements 6, can be made from a material like an elastomer that provides for the compliancy on contact between it and the cover element 4. The patterning device 10 may be additionally attached to a substrate that is at least partially translucent and harder in order to facilitate handling and bulk-positioning of the light-guiding element.

The resolution of the present approach is not strictly proportional to the wavelength of the light source, as in conventional photolithography systems. Due to the fact that the light-guiding protrusion element 6 replaces the conventionally used mask, resolutions around $\lambda/2n$ can be obtained.

Conventionally available resists can be used as the cover element 4. Generally suited are photoresists based on cresols (Novalacs), as are acrylates or styrenes and their mixtures, for example. Positive as well as negative tone resists can be employed. One may also use amplified resists to improve the ratio (width/depth) the features which are provided after exposure and development. Also used may be an optically resist, such as the SU-8 negative tone resist that itself displays differential light guiding effects on exposure. Bilayer, trilayer and top-surface imaging-resist schemes are all compatible and well suited for use with the present light-coupling structures. Details about resists are given in text books and other publications such as the special issue of IBM's Journal of Research and Development with title "Optical Lithography", Vol. 41, No. 1/2, January/March 1997.

The exposure time can be chosen dependent on various parameters such as the light wavelength, absorbance in the light-guiding protrusion element 6, sensitivity of the material of the cover element 4, coupling efficiency of the patterning device 10 (or light-guiding protrusion element 6 in the present context), thickness of the cover element 4, contrast, and so forth.

In the following, a patterning device 10 with several light-guiding protrusion elements 6 and a method for making such a patterning device 10 are described in detail. Well suited are polymers. The patterning device 10 can be formed as a replica from a master structure.

Several properties of the ideal polymer to form the patterning device 10 as a replica can be identified. First, the polymer should have a refractive index that is similar to that of the targeted cover element 4. Second, the polymer should be capable of stable structure definition on its surface where the aspect ratio, i.e. the thickness of the structure to one of its areal dimensions, is at least 0.1. Third, the material should be tough and somewhat compliant, allowing it to adapt to the surface of the cover element 4 on which it is placed, particularly where no other forces than gravity and interfacial energy are used to bring the two in contact. Fourth, the surface energy of the polymer is ideally low so that its contact with the cover element 4 is reversible and does not leave materials on the cover element 4 or tend to destroy it. Fifth, the material should be somewhat translucent to the targeted wavelength of illumination in order to allow the passage of the light 7 through, and out of, the light-guiding protrusion elements 6. Sixth, the material should flow at some stage in its processing, either by melting it or by forming the polymer directly in the mold by chemical reaction. Seventh, the density changes and stresses associated with the previous requirement should be insufficient to cause breakage of the master or its incomplete replication. Eighth, the material should allow conformal contact, as described above. Siloxanes, made by addition of low-molecular-weight silane containing crosslinkers to mixtures of branched and linear olefin-terminated siloxane backbones have proved particularly advantageous in the above regards. Siloxane materials resulting from such mixtures can have surface energies of ~25 mN/m, strengths of ~ 10 Mpa and a viscosities of ~1000 cSt in their pre-polymer form and allow the formation of useful light-guiding protrusion elements 6 at, below, 100 nm feature scales, while maintaining the necessary conformity. Other materials based on carbon elastomers are also well suited to the application, as are combinations of these materials with silica or siloxane-containing fillers. Combinations of organic materials and inorganic materials into composite structures can prove particularly advantageous where a given material type is chosen to satisfy the required physical properties of a specific light-guiding protrusion element 6, as discussed above.

In general, the material used for the formation of the light-guiding protrusion element 6 should be such that viable definition of features down to the size of the features - which are to be formed in a cover element 4 and maybe also in the underlying substrate 2, since the present process is a true 1:1 process - possible. In other words, if a pillar or ridge of 90nm width is to be formed on a semiconductor substrate, the width of the respective light-guiding protrusion element 6 has to be 90nm, too, provided that a positive resist is used as the cover element 4.

If the patterning device 10 is structured, it can be made by curing a polymer on a master with the negative structure of the surface of the desired light-guiding protrusion element 6. This results in an elastomeric solid with the light-guiding protrusion element 6. The master can be formed using electron beam definition, for example. The time and money invested in the making of a precise, high resolution master is amortized by making many replicas, each capable of being used in the manufacturing of semiconductor circuits, for example. Each of the replicas can be used several times and if made of elastomer does not tend to break.

The light-guiding protrusion element 6 should be designed such that it can be brought into conformal contact with the cover element 4, because the whole process relies on the efficient coupling of the light 7 from the light-guiding protrusion element 6 into the cover element 4.

The light-guiding protrusion elements 6 can have almost any shape and size. The most important advantage of the invention lies in the fact that the patterning device 10 in fact can also be used in an unstructured version which simply makes use of the structures on the substrate 2. This embodiment can also be seen as one big single light-guiding protrusion element 6.

For master formation, a silicon wafer can be covered with a 100 nm thick layer of plasma-deposited silica in a homogeneous film. Polymethylmethacrylate polymer (980K), dissolved in clorobenzene to 15% solids, can be spun on the wafer to form a 100 nm thick film of this resist material on the substrate 2. The resist is selectively altered by its patterned exposure to a current of 100 KeV electrons using an e-beam mask-writer tool. Differential dissolution of the resist in acetone after exposure reveals a pattern of features in a periodic array with sizes down to 100 nm on the substrate. This pattern is transferred into the silica layer on the substrate 2 using a fluorine based reactive ion etching (RIE) chemistry that has an excellent selectively towards silicon. The RIE process stops when the underlying silicon layer is reached thus ensuring a uniform development of features in the silica layer with squared bottoms formed at the interface with silicon. Later this fact will help to insure the excellent definition of the light-guiding protrusion elements 6. The substrate 2 is ashed in an oxygen plasma to remove residual organics and then 10 nm of a fluorinated polymer is deposited by a plasma-assisted process all over the substrate 2 to provide it with a low-surface free-energy coating (15 mN /m). This layer is essential to allow release of cured formed replica in the subsequent processing steps.

The light-guiding protrusion element 6 can be prepared by its replication from the master in that a mixture of ~ 6.5g vinylmethyl siloxane-dimethyl siloxane copolymer (~ 1000 cSt, VDT 731 Gelest, Karlsruhe, Germany) and ~ 2 g methylhydrosiloxane-dimethylsiloxane copolymer (30 cSt, HMS 301, Gelest) and ~ 450 mg of fused silica particles (~ 20 nm in size, Gelest) is prepared with ~ 5 ppm of platinum catalyst. This mixture is poured directly onto the aforementioned master and cured in an oven at 60° for 24 h. The replica is released by peeling it by hand from the master. The replica has a surface energy of 23 mN/m, a strength of 10 Mpa and a hardness which is about 3% of that of glass. All of the features present on the master are faithfully reproduced in its replica according to the procedure above as determined by scanning electron microscopy (SEM), where a depression on the master is now a raised structure on the surface of the replica. A gold layer, 5 nm thick, is evaporated on top of the structures side of the replica. The replica so treated is then placed in contact with a silicon wafer having a layer of 1 nm of titanium followed by a layer of 30 nm of gold freshly evaporated on its surface; the gold on this surface is then treated by its exposure to the vapors of a 1,10 decanedithiol (Aldrich) for 5 minutes. After contact and release occurs between the surface of the replica and the treated gold surface of the silicon wafer, gold is selectively removed from the tops of the protruding surfaces of the replica, left behind on the treated gold surface of the silicon wafer by the adhesive contact between the two, mediated by the presence of thiol-terminated organic molecules at their interface.

A 600 nm thick layer of Shipley 6612 (novalac) photoresist is spun-coated on the surface of a silicon wafer previously treated with hexamethyldisilazide acting as an adhesion promoter for the cover element 4. A 20-minute-bake of the substrate 2 is carried out at 90°. The light-guiding protrusion element 6 described above is placed by hand on top of the photoresist which makes out the cover element 4 on the substrate 2 where gravity and interfacial forces between the two maintains their intimate conformal contact. Pulses from a KrF laser, (200, each 20 ns and 300 mJ) are used as the light 7 to expose the cover element 4. Then follows the developing process with a Shipley 400K according to the instructions of the manufacturer.

Because the light-guiding protrusion elements 6 are typically transparent, check-and-correct schemes of alignment become possible. The position of the light-guiding protrusion elements 6 can be iteratively manipulated on the cover element 4 until a final positional placement is satisfied prior to the exposure. This type of alignment is not obviously possible with the currently used optical projection techniques that must rely instead on absolute knowledge of the substrate's location to achieve overlay accuracy. In fact, the needed alignment is here coarser since the light-guiding protrusion elements 6 need not have the definition of the finally to produce pattern. This definition is already provided by the substrate 2 with its substrate protrusion elements 3. Hence, the alignment can be left more unprecise or even totally renounced in the case of an unstructured patterning device 10.

It is another advantage that the topology of the substrate 2 need not be strictly planar. The light-guiding protrusion elements 6 allow some accommodation of surface roughness.

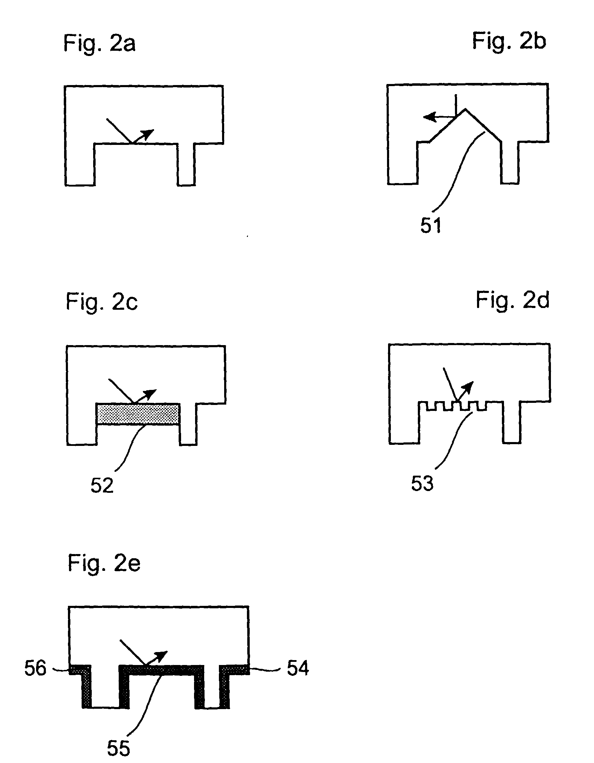

The light-guiding protrusion elements 6 may be combined with additional elements as illustrated in Figures 2a-2e. The shown light-guiding protrusion elements 6 have all in common that there are special means provided such that the internal reflections at the interface between the light-guiding protrusion element 6 and air are improved.

In Figure 2a, the simplest approach is shown. The abrupt change in refractive index at the interface provides for a back-reflection of the incident light 7.

In Figure 2b, an embodiment is shown where the area between two light-guiding protrusion elements 6 has sloped interfaces 51 to improve the internal reflections.

Another approach is shown in Figure 2c. Here, a reflecting layer 52, such as a metal (gold) layer is deposited that area to increase the internal reflection, as shown in the example above.

A grating 53, as shown in Figure 2d, shows similar effects.

The light-guiding protrusion elements 6 described so far can be improved by applying a light-blocking layer 54 to certain of the interfaces of the structure, as schematically illustrated in Figure 2e. The light-blocking layer 54 in the present example covers the interfaces 55 of the patterning device 10 facing the substrate 2 and maybe some parts of the cover element 4, as well as the side walls 56 of the light-guiding protrusion elements 6.

In the following it isdescribed how the patterning device 10 can be used in a manufacturing process.

First, a cover element 4 is formed on a substrate 2 to be patterned. Different methods are known in the art how such a cover element 4 can be formed. Then the patterning device 10 defined according to the present invention, is put onto the cover element 4. If the patterning device 10 is flexible, it may be rolled onto the cover element 4. The position of the patterning device 10 with respect to the substrate may be checked optically. A positioning apparatus may be used to correct the position providing for a lateral relative movement between the patterning device 10 and the substrate 2.

Now the patterning device 10 may be pressed against the cover element 4 to improve the coupling efficiency. This step can be omitted depending on the circumstances. The light source 5 is then turned on either in constant or pulsed mode. The light 7 emitted by the light source 5 and coupled into the patterning device 10 is automatically guided towards the light-guiding protrusion elements 6, where it is directly coupled into the cover element 4. The cover element 4 is exposed right underneath these light-guiding protrusion elements 6. At the end of the exposure process (if sufficient exposure has been achieved) the light 7 is turned off, and the patterning device 10 is removed. Several wavelengths of the light 7 can be used to help suppress interference effects in the waveguiding structures when these structures have a variety of width, as can occur when these structures are larger than the nominal wavelengths.

Anti-reflection coatings and other such means can be added to the substrate 2 or the cover element 4 to suppress backreflections.

Then, the light-sensitive material of the cover element 4 is developed using a development step. In case of a positive-tone resist, the exposed parts of the cover element 4 are removed during the development step. If a negative-tone resist is employed, only those parts of the cover element 4 which were not exposed to the light 7 are removed. A subsequent step can deposit also for the negative-tone example the auxiliary layer which then is deposited on the substrate 2, on the exposed parts of the cover element 4 and on the substate protrusion elements 3 which no longer bear any part of the cover element 4.

A not depicted embodiment comprises a combination of structured patterning device 10 and structured substrate 2 in which the contact between at least one light-guiding protrusion element 6 and the cover element 4 is only partial in that the facing surfaces of them only partially overlap. This variation can be used to obtain even smaller features and particularly only partial patterns on top of the substrate protrusion elements 3, although the alignment needs only the standard definition dictated by the structure definition of the substrate 2.

A hard-backing step may be carried out before the next steps.

The remaining pans of the cover element 4 now can serve as a mask protecting certain areas of the substrate 2 from being etched away. A wet or dry-etch step can then be used to transfer the lateral shape and size of the remaining parts of the cover element 4 into the substrate 2. Then, the cover element 4 is completely removed, e.g. ashed away.

Alternatively, e.g. a mesa -structure can be built, by depositing the auxiliary layer on the arrangement. A lift-off procedure can remove the cover element 4 with the layer elements 9 on it.

The contact between the patterning device 10, herein also referred to as stamp, and the substrate 2 via the cover element 4 allows another contrast mechanism with a potentially higher lateral resolution: The cover element 4 in form of molecules can serve as a sort of "ink" which is stamped selectively onto the substrate 10.

The patterning device 10 can therefor be partially or totally covered with the molecules which are then "stamped" onto the substrate 2, which here is structured to have the depressions and the protrusion elements 3. For making the molecules stick to the stamp 2, some preparation or derivatization may be needed. For instance a self-assembling monolayer of molecules may be created on the stamp 10, which then is transferred to the substrate 2.

The molecules are then only applied to the substrate 2 in areas of mechanical contact between the stamp 10 via the cover element 4, i.e. the molecules, and the substrate 2 due to the light-guiding property of the patterning device 10. This means that the molecules 4 only adhere to the substrate 2 where they are in contact with the substrate 2 and the stamp 4, and are illuminated. After lifting the stamp 10 off the substrate 2, a pattern of the molecules 4 remains on the substrate 2, respectively on its protruding elements 3.

The same is possible with any intermediate layer which covers the substrate 2, i.e. also a photoresist. Hence the substrate 2 with the photoresist, as depicted in figure 1, can be also patterned with this method. Generally, when in this description a substrate 2 is mentioned, any sequence of layers together serving as the substrate 2 is meant. In that sense the substrate together with an intermediate layer is again a substrate. The molecules 4 can also be applied to the structured substrate 2 first and then be brought into contact with the stamp 10 which then provides for the selective illumination.

The application of the molecules 4 as preparation for the stamping process can either be done selectively by pressing a sort of ink cushion with the molecules 4 on the stamp 10, where they then adhere only to the protruding sections of the stamp 10 in the case the stamp 10 is structured, or generally by dipping the the stamp 10 into a molecule-containing liquid such that the molecules 4 adhere to the whole immersed surface of the stamp 10. In principle it is also possible to have the molecules 4 brought with one of this methods to the substrate surface before contacting with the stamp 10. The molecules 4 chemically modified by illumination can then be separated from the non-modified molecules 4 by some subsequent process step, which e.g. removes the non-modified molecules 4 from the substrate surface.

Replication that is based on contact-printing naturally suffers from imperfect layers because entropically a 100% complete layer is not favourable. Combination of the mechanical transfer of the molecules 4 with a light-induced chemistry that selectively processes the contacting molecules 4 has the potential to multiply both contrast mechanisms and, therefore, create a resulting contrast that is higher than is possible with each separate method alone, because with light as an external energy source the system is entropically no longer closed and the reaction can be driven to 100% completion. An example of a light-activated molecule 4 that selectively only reacts when illuminated is a photocleavable acid generator and linear alkane molecule terminated with an aldehyd function. In the case, when the molecules 4 are themselves applied to the substrate or the stamp in a patterned arrangement, the contrast is again increased. Also different molecule types can be used in parrallel or sequentially.

Contrast enhancement can also be achieved on structured resist surfaces that have been produced using embossing. In theory, a shim that is pressed ontop of a spinned resist displaces the material above its glas transition temperature completely below protrusions of the shim and the material flows into depressed areas. This process is, however, limited to only small lateral dimensions and requires a constant ratio between protrusion and depression area for materials with a usual viscosity. In all other cases the resist cannot be fully displaced and has to be post-processed, in order to obtain areas with and without resist. It is known to remove this remaining flat layer by a uniform etch that also removes part of the thick structures and, thereby, reduces the total thickness contrast.

The invention can here be used to perform substrate patterning even with the embossed photoresist, which represents the cover element 4 which is structured in itself, i.e. has depressions and protrusion elements 11.

Figure 4 shows an arrangement with the substrate 2 being unstructured while the thereupon deposited cover element 4 is structured and hence comprises protrusion elements 11. The structuring of the cover element 4 may be the result of an embossing step. Upon this arrangement the stamp 10, which here is also unstructured, is lowered and gets into contact with the protrusion elements 11. Upon illumination with the incident light 7, the light enters the cover element 4 to the major extent through the protrusion elements 11. Hence the cover element 4, which is made up of light-sensitive material, is chemically modified mainly at the positions of the protrusion elements 11. A subsequent developing step hence is able to remove the areas beneath the protrusion elements 11. The protrusion elements 11 are not harmed and hence the aspect ratio of the cover element features is even improved.

Illumination of the photosensitive resist material through the stamp 10 can be used to selectively remove material outside zones of mechanical contact and even to photochemically harden the protruding elements of the cover element 4. The overall contrast can thereby be maximized.

For example, to produce 100 nm wide features, a 200 nm thick layer of a negative resist, e.g. NA 410 diluted with additional solvent, is spun onto the substrate and embossed using a shim with a 100 nm deep pattern. This creates a 100 nm high and 100 nm wide topography on the resist surface. An unpatterned PDMS stamp, e.g. VDT 731 or HMS 301, is put into contact with the surfaces of the protrusions of the cover element 4 but not with the surfaces of its depressed regions, and illuminated. This creates an amplitude contrast which is used to selectively harden the protrusions as well as the volume directly beneath this region. After that, the exposed substrate 2 with the cover element 4 is immersed into a developer thus creating 100 nm wide and 200 nm high patterns and stripping the resist in the other areas. This resist pattern can now be directly used in a RIE for transfer of the pattern into Si for example. The maximal depth of the pattern in Si is restricted by the etching ratio of resist versus Si (for NA 410 this ratio is typically 1:10), thus up to 2000 nm deep and 100 nm wide structures can be produced. The minimal lateral feature size using this method is restricted to 1/2n or 60 nm for 248 nm light and a refractive index of 1.5.

Standing waves evolve in the light-guiding protruding elements 6 on the stamp surface having dimensions larger than the wavelength of the light in the material. The typical dimensions of these patterns are of the order of this wavelength but local intensities on the stamp surface can vary a lot. This contrast generation mechanism can be combined with the substrate protrusion elements 3 on the substrate surface or the light-guiding protrusions on the stamp 10 to further enhance contrast, and thus make use of interference effects to enhance contrast. If the substrate protrusion elements 3 are in registry with the peaks in the standing waves they are selectively illuminated. Other substrate protrusion elements 3 that are in regions of local minima are not exposed.

When the stamp 10 is operated in an evanescent mode, i.e. using total reflection at the contacting regions of the stamp 10, this allows definition of higher lateral contrast than with perpendicular illumination. This is achieved by inclining the illuminating rays in accordance with the refractive index difference at the interface between the stamp surface and the cover element 4 or the substrate 2. To obtain this effect, a thin low-refractive index material can be inserted directly between the stamp 10 and the cover element 4. This material can be solid but also be simply air or any other gas or low-refractive liquid. With the higher contrast, pattern sizes can be as small as Lambda/10. Generally speaking, evanescent fields do have higher field gradients. The disadvantage of this is that fields are strongly attenuated as function of penetration depth into the resist. This is not serious when the fields are used to illuminate top layers like in top-surface-imaging schemes. In addition, the application of this process to the substrate protruding elements 3 on the substrate 2 allows a more homogeneous distribution of the exposure as function of proximity to the edge of the pattern. Like in top-surface-imaging schemes, the diffusive material may be applied after the exposure. Top-surface-imaging schemes can be improved by direct application of the diffusive material during or after the exposure. Due to the small thickness of molecular layers, this method can be applied advantageously with the above described molecular cover element 4.

As an example, to replicate patterns below 60 nm a hydroxystyrene resist is embossed with a shim having structures with an aspect ratio of 1. The thereby generated patterned resist surface is exposed with the evanescent stamp 10 to increase the permeability of the top layer of the protrusions of the cover element 4. The whole substrate 2 is then exposed to vapours of hexamehyldisilazane. The different permeability favour saturation of the top layer of the sub 60 nm posts creates the desired improved resistivity against the $O_2$ plasma. Thus the aspect ratio of the 60 nm resist features can be amplified. The resist is then used in a standard silicon RIE for transfer into the substrate material. Maximal depths can be larger than 10 times the width. The power of this method is the amplified resist structure which allows high aspect ratio Si features to be produced and is also better for plasma-based ion implantation techniques.

Generally, the described method is used to amplify an existing resist structure whatever the previous fabrication method was.

Figure 5 shows a patterned resist structure illuminated with a stamp using evanescent light to create a thin layer with increased permeability. This structure is filled with HMDS to harden it in the subsequent $O_2$ plasma etch and to allow amplificaton of aspect ratio of pattern.

In detail, figure 5 shows the flat, unstructured substrate 2 with the structured cover element 4 on it. The stamp 10 is driven in the evanescent mode and is in contact with the cover layer 4 via its protrusion element 11. The incident light does mainly not leave the stamp 10, but creates the evanescent field which only chemically modifies the material of the cover element 4 at the top of the protrusion element 11, i.e. at the area which is subjected to the evanescent field. As next step it is supposed to use the modified top layer as means for structuring the cover element 4 totally, i.e. to be able to remove the areas beneath the protrusion element 11. Therefor a directed material removal step can be used which affects not the modified cover element material but only the non-modified cover element material.

Generally, the structure of the cover element 4 can either derive from being itself structured, hence having different thickness in adjacent regions, or as well derive from a structure of an underlying element, whose structure is reproduced or reflected in the cover element 4, e.g. during deposition of the cover element 4 on the structured underlying element. This element can also be the substrate 2. These structuring effects can also be combined. The cover element 4 hence does not provide overall contact between the stamp 10 and the substrate 2 but represents a spatially selective intermediate element which at predetermined positions builds a bridge between the stamp 10 and the substrate 2 such that a pattern is generated on the substrate 2, when the stamp 10 is illuminated and serves as a waveguide. All described or depicted elements, method steps and arrangements can be combined.

**Claims**

1. Patterning device with which incident light (7) is guidable at least partially to at least one cover element (4)

   - which is in contact with said patterning device (10), and

   - which comprises light-sensitive material, preferably a positive- or a negative-tone photoresist or a material with an illumination-dependent chemical property, and

   - which is structured to have depressions and protrusion elements (11) and is in contact with a surface of a substrate (2) and/or which is in contact with said surface of said substrate (2), said surface being structured to have substrate protrusion elements (3).

2. Patterning device according to claim 1, characterized in that it comprises an elastomer, preferably a polymer.

3. Patterning device according to claim 1 or 2, characterized in that it comprises a material which has a refractive index which effects that the incident light (7) is guided therein by internal reflection.

4. Patterning device according to one of claims 1 to 3, characterized in that the light-sensitive material of the cover element (4) has a refractive index which at least approximately matches the refractive index of the material of the patterning device (10).

5. Patterning device according to one of claims 1 to 4, characterized in that a difference in the refractive indices of the patterning device (10) and of the cover element (4) is reduced, preferably by a material, preferably a viscous oil or polymer, whose refractive index lies between the refractive indices of said patterning device (10) and of said cover element (4).

6. Patterning device according to one of claims 1 to 5, characterized in that it is designed to, and/or that reflecting means (8) is provided to, reduce the amount of the incident light (7) which leaves said patterning device (10) in areas other than at the position of contact to the cover element (4).

7. Patterning device according to claim 6, characterized in that the reflecting means (8) comprises a cover layer and/or a Bragg-grating.

8. Patterning device according to one of claims 1 to 7, characterized in that it comprises at least one light-guiding protrusion element (6) which is in contact with the cover element (4).

9. Method for patterning a substrate, comprising the steps of

   - providing a substrate (2) with at least one substrate protrusion element (3) on its surface, lowering or attaching a layer of light-sensitive material on said substrate (2), such that a cover element (4) is created thereby, or

   - providing on a substrate (2) a cover element (4) which itself is structured, such that it comprises protrusion elements (11),

   - bringing a patterning device (10) into contact with said cover element (4),

   - illuminating said patterning device (10) with incident light (7) which is guided at least partially to said cover element (4) which thereby is exposed to said light (7), and

   - removing said patterning device (10) from said cover element (4).

10. Method for patterning a substrate, according to claim 9, comprising the further step of removing either the part of the cover element (4) which has been exposed to said light (7) or the part of the cover element (4) which has not been exposed to said light (7).

11. Method for patterning a substrate, according to claim 10, comprising the further step of depositing an auxiliary layer on the remaining part of the cover element (4) and on the protrusion element (3), respectively on the remaining part of the cover element (4) and on the substrate (2), whereby layer elements (9) are generated, and removing said part of said cover element (4) with said thereupon deposited layer element (9).

12. Method for patterning a substrate, according to one of claims 9 to 11, wherein the patterning device (10) is held on the cover element (4) by means of gravitational and interfacial forces only.

**13.** Method for patterning a substrate, according to one of claims 9 to 12, wherein the wavelength of the incident light (7) is chosen such that the height of the substrate protrusion element (6) is a multiple of it.

**14.** Method for patterning a substrate, comprising the steps of providing a substrate (2) with at least one substrate protrusion element (3) on its surface, depositing a layer of light-sensitive material on a patterning device (10) such that a cover element (4) is created thereby, bringing the patterning device (10) into contact with said substrate (2), illuminating said patterning device (10) with incident light (7) which is guided at least partially to said cover element (4) which thereby is exposed to said light (7) and removing said patterning device (10) from said cover element (4).

**15.** Method for patterning a substrate, according to claim 14, comprising the further step of removing either the part of the cover element (4) which has been exposed to said light (7) or the part of the cover element (4) which has not been exposed to said light (7).

Fig. 1a

Fig. 1b

Fig. 1c

Fig. 1d

Fig. 2a

Fig. 2b

51

Fig. 2c

52

Fig. 2d

53

Fig. 2e

56

54

55

Fig. 3

Fig. 4

Fig. 5

European Patent Office

**EUROPEAN SEARCH REPORT**

Application Number

EP 99 12 0594

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | US 5 292 625 A (WEBER MICHAEL F ET AL) 8 March 1994 (1994-03-08) | 1,3-11, 14,15 | G03F7/00 G03F7/20 |
| Y | * the whole document * | 2,12,13 | G03F1/14 |
| Y | SCHMID H ET AL: "Light-coupling masks: An alternative, lensless approach to high-resolution optical contact lithography" 42ND INTERNATIONAL CONFERENCE ON ELECTRON, ION, AND PHOTON BEAM TECHNOLOGY AND NANOFABRICATION, CHICAGO, IL, USA, 26-29 MAY 1998, vol. 16, no. 6, pages 3422-3425, XP002133155 Journal of Vacuum Science & Technology B (Microelectronics and Nanometer Structures), Nov.-Dec. 1998, AIP for American Vacuum Soc, USA ISSN: 0734-211X * the whole document * | 2,12,13 | |
| A | DONG QIN ET AL: "Photolithography with transparent reflective photomasks" FOURTH INTERNATIONAL WORKSHOP ON THE MEASUREMENT, CHARACTERIZATION, AND MODELING OF ULTRA-SHALLOW DOPING PROFILES IN SEMICONDUCTORS, vol. 16, no. 1, pages 98-103, XP002133156 Journal of Vacuum Science & Technology B (Microelectronics and Nanometer Structures), Jan.-Feb. 1998, AIP for American Vacuum Soc, USA ISSN: 0734-211X | | TECHNICAL FIELDS SEARCHED (Int.Cl.7) G03F |

-/--

The present search report has been drawn up for all claims

| Place of search | Date of completion of the search | Examiner |
|---|---|---|
| THE HAGUE | 20 March 2000 | Haenisch, U |

EPO FORM 1503 03.82 (P04C01)

EP 1 001 311 A1

## European Patent Office

# EUROPEAN SEARCH REPORT

Application Number

EP 99 12 0594

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| A | SCHMID H ET AL: "LIGHT-COUPLING MASKS FOR LENSLESS, SUB-WAVELENGTH OPTICAL LITHOGRAPHY" APPLIED PHYSICS LETTERS,US,AMERICAN INSTITUTE OF PHYSICS. NEW YORK, vol. 72, no. 19, 11 May 1998 (1998-05-11), pages 2379-2381, XP000755967 ISSN: 0003-6951 --- | | |
| A | ANON.: "LITHOGRAPHIE MIT "LICHTSTEMPELN" TECHNISCHE RUNDSCHAU,CH,HALLWAG VERLAG. BERN, vol. 90, no. 19, 9 October 1998 (1998-10-09), page 20 XP000824413 ISSN: 1023-0823 --- | | |
| A | WO 98 12603 A (HERZIG HANS PETER ;BLATTNER PETER (CH); VOELKEL REINHARD (CH); HUG) 26 March 1998 (1998-03-26) ----- | | TECHNICAL FIELDS SEARCHED (Int.Cl.7) |

The present search report has been drawn up for all claims

| Place of search | Date of completion of the search | Examiner |
|---|---|---|
| THE HAGUE | 20 March 2000 | Haenisch, U |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

19

## ANNEX TO THE EUROPEAN SEARCH REPORT
## ON EUROPEAN PATENT APPLICATION NO.

EP 99 12 0594

This annex lists the patent family members relating to the patent documents cited in the above-mentioned European search report.
The members are as contained in the European Patent Office EDP file on
The European Patent Office is in no way liable for these particulars which are merely given for the purpose of information.

20-03-2000

| Patent document cited in search report | | Publication date | Patent family member(s) | | Publication date |
|---|---|---|---|---|---|
| US 5292625 | A | 08-03-1994 | EP<br>JP | 0564364 A<br>6049673 A | 06-10-1993<br>22-02-1994 |
| WO 9812603 | A | 26-03-1998 | NONE | | |

For more details about this annex : see Official Journal of the European Patent Office, No. 12/82